(19) **Europäisches Patentamt European Patent Office Office européen des brevets**

(11) **EP 2 037 571 B1**

(12) **EUROPEAN PATENT SPECIFICATION**

(45) Date of publication and mention
of the grant of the patent:
**21.01.2015 Bulletin 2015/04**

(51) Int Cl.:
**H03D 7/14** (2006.01)

(21) Application number: **08164364.5**

(22) Date of filing: **15.09.2008**

(54) **A mixer for downconversion of RF signals**

Mischer zur Abwärtsmischung von RF-Signalen

Mélangeur pour la conversion à la baisse de signaux RF

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **13.09.2007 GB 0717865**

(43) Date of publication of application:
**18.03.2009 Bulletin 2009/12**

(73) Proprietor: **Cambridge Silicon Radio Limited Cambridge CB4 0WZ (GB)**

(72) Inventors:
• **Christoffers, Niels**
 **Cambridge CB4 6ZG (GB)**
• **Sornin, Nicolas**
 **38700 La Tronche (FR)**

(74) Representative: **Gillard, Matthew Paul et al Withers & Rogers LLP 4 More London Riverside London SE1 2AU (GB)**

(56) References cited:
**US-A- 5 613 233      US-A1- 2006 040 636**

• **RAMIAH H. ET AL.: "High linearity 0.18microm CMOS Mixer with current draining technique." TENCON 2005 MELBOURNE, AUSTRALIA, 21 November 2005 (2005-11-21), XP031015539 Piscataway, NJ,USA**
• **MASSIMO BRANDOLINI ET AL: "A 750 mV Fully Integrated Direct Conversion Receiver Front-End for GSM in 90-nm CMOS", IEEE JOURNAL OF SOLID-STATE CIRCUITS, IEEE SERVICE CENTER, PISCATAWAY, NJ, USA, vol. 42, no. 6, 1 June 2007 (2007-06-01), pages 1310-1317, XP011184874, ISSN: 0018-9200, DOI: 10.1109/JSSC.2007.897131**

## Description

### Field of the Invention

The present invention is related to a mixer for down conversion of RF (radio frequency) signals. The invention is particularly but not exclusively related to a mixer which reduces second order distortion using a common mode feedback loop.

### Background

Second order intermodulation distortion (IM2) in mixers is caused by self missing within the mixer.

Second order components from the self mixing are within low frequency bands where they can super pose desired signals and can therefore aggravate subsequent signal processing.

Some mixers, such as Gilbert-type mixers, have a differential output such that IM2 exists as a removable common-mode signal when both individual output paths are identical. However, due to duty-cycle errors as a consequence of mismatches in the switching transistors, the IM2 in the common mode of the RF-input transistors leaks into the differential mode at the mixer output.

The system described in Brandolini et al, "A 750mV fully Integrated Direct Conversion Receiver Front-End for GSM in 90-nm CMOS", IEEE Journal of Solid State Circuits, Vol. 42, No. 6, June 2007 provides for the removal of second order distortion using a common mode feedback loop.

However, all the embodiments in this document describe the use of two coils to short IM2 at the input transconductor.

Coils can occupy a large area particular on an integrated circuit. In addition, use of coils will lower the drain impedance of the RF transistors in the document, thereby reducing the achievable conversion gain.

US 2006/0040636 describes a mixer capable of detecting or controlling a common mode voltage thereof.

It is object of the present invention to provide a mixer which reduces second order distortion using a common mode feedback loop which overcomes the disadvantages of the prior art, or at least provides a useful alternative.

### Summary of the Invention

According to a first aspect of the invention there is provided a mixer for downconversion of RF signals, comprising:

at least one RF transistor;
at least one switching pair connected to the drain current of the at least one RF transistor;
a common mode sensing component configured to detect deviations in the common mode output of the switching pair from a specified output; and
at least one feedback path from the common mode sensing component to the drain current of the at least one RF transistor;

wherein the feedback path is configured to subtract the deviation from the drain current of the at least one RF transistor.

The deviation may be amplified before being subtracted from the drain current. An amplifier within the common mode sensing component may be used for this purpose.

It is preferred that the mixer further comprises a feedback path from the common mode sensing component to the drain current of each RF transistor.

When there are at least two RF transistors, the gains of each feedback path may be mismatched to the RF transistors.

The deviation may be directly subtracted from the drain currents of the RF transistor.

The common mode sensing component may comprise a resistive divider and a PMOS-transistor.

The specified output may be a ground reference defined voltage.

The mixer may comprise two RF transistors and two switching pairs.

According to a further aspect of the invention there is provided a method for reducing second order distortion in a downconversion mixer, including the steps of:

detecting deviations in the common mode output of at least one switching pair from a specified output; and
subtracting the deviation from the drain currents of at least one RF transistor connected to the at least one switching pair.

According to a yet further aspect of the invention there is provided a mixer for downconversion of RF signals, comprising:

at least one RF transistor;
at least one switching pair connected to the drain current of the at least one RF transistor;
a common mode sensing component configured to detect deviations in the common mode output of the switching pair from a specified output; and
at least one feedback path from the common mode sensing component to the at least one RF transistor;

wherein the feedback path is configured to modify the voltage of the at least one RF transistor in correlation with the deviations.

Preferably, the feedback path is configured to modify the gate-source voltage of the at least one RF transistor.

**Brief Description of the Drawings**

Embodiments of the invention will now be described, by way of example only, with reference to the accompanying drawings in which:

Figure 1: shows a simplified single balanced Gilbert mixer;

Figure 2: shows a double balanced mixer;

Figure 3: shows a mixer in accordance with an embodiment of the invention;

Figure 4: shows a mixer in accordance with an embodiment of the invention with mismatched gains $A_+$ and $A_-$ to reduce IM2 due to mismatched $g_{m2+}$ and $g_{m2-}$;

Figure 5: shows a mixer in accordance with an embodiment of the invention with a resistive divider connected to PMOS-transistors;

Figure 6: shows a mixer in accordance with an embodiment of the invention using an operational amplifier to achieve a higher open-loop gain and to obtain less sensitivity to VDD-variations.

**Detailed Description of Preferred Embodiments**

The present invention provides a mixer which reduces second order distortion (IM2) by subtracting the deviation of the common mode of the mixer from a specified CM-current from the drain currents of the RF transistors of the mixer or by modifying the voltage of the RF transistors in correlation with the deviation.

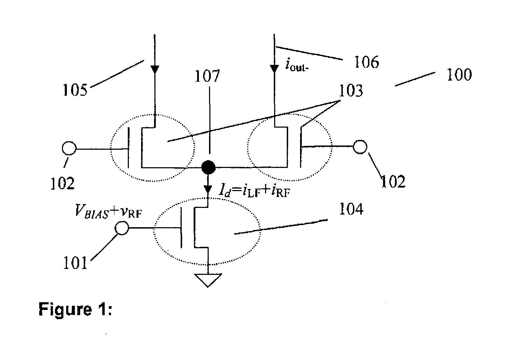

Referring to Figure 1, an explanation of how IM2 is generated will be provided. A simplified single-balanced mixer 100 is shown in Figure 1 which is unbalanced at its RF-input 101 ($V_{bias}$ superimposed by the RF-voltage $v_{RF}$) and normally balanced at its LO-input 102 ($v_{lo+}$ to $v_{lo-}$). The LO-input 102 voltage connected to two switching transistors 103 is assumed to be high enough to steer the total drain current of the RF-input transistor 104 to either the positive 105 or negative 106 output branch of the mixer during the first or second half of the LO-period respectively. The drain-current 107 of the input transistor comprises a low-frequency component $i_{LF}$ and a high-frequency component $i_{RF}$. The RF component will be mixed to the RF-frequency plus and minus the LO-frequency. Most of the LF-component will be mixed to the LO frequency. However, a part of it will leak to the output of the mixer in case of a non-50% duty cycle of the switches.

Let the LF component vary slow enough to be regarded constant during one LO-period. Assuming moreover the point in time during a period of the LO where the switches switch the RF-current from the positive to the negative branch is denoted $T_S$ the LF content of the differential output current will be

$$0,5 \cdot \overline{i_{\text{out}+} - i_{\text{out}-}} = 0.5 \cdot \frac{1}{T} \cdot \left[ \int_0^{T_s} i_{\text{out}+} \, \mathrm{dt} - \int_{T_s}^{T} i_{\text{out}-} \, \mathrm{dt} \right] = 0.5 \cdot \left( \underbrace{i_{\text{LF}} \frac{2T_s - T}{T}}_{=:i_{undesired}} + \underbrace{\frac{\int_0^{T_s} i_{rf} \, \mathrm{dt} - \int_{T_s}^{T} i_{rf} \, \mathrm{dt}}{T}}_{=:i_{desired}} \right) \quad (1)$$

where the over-bar indicates the time average and T is the LO-Period, and the low-pass filtering has been approximated by an averaging across one LO-cycle.

The desired current in Equation (1), denoted $i_{desired}$, arises from mixing the RF-frequency with the LO-frequency, and will be superposed by an undesired component $i_{undesired}$, which arises from leakage of the low-frequency currents to the mixer output. The leakage will be zero for $2 \cdot T_S = T$, i.e. a 50% duty cycle. Practically, an exact 50% duty cycle cannot be achieved, such that leakage is inevitable.

The LF-components can be computed using a transistor model, for instance that of Schichman and Hodges. For the circuit of Figure 1 the drain-current of the input transistor will be:

$$I_d = 0.5 \cdot \mu \cdot C_{ox} \cdot W/L \cdot (V_{bias} + v_{rf} - V_T)^2$$
$$= 0.5 \cdot \mu \cdot C_{ox} \cdot W/L \cdot [(V_{bias} - V_t)^2 + 2 \cdot (V_{bias} - V_t) \cdot v_{rf} + v_{rf}^2]$$
$$= I_{bias} + i_{rf} + g_{m2} \cdot v_{rf}^2$$

With

$$I_{bias} = 0.5 \cdot \mu \cdot C_{ox} \cdot W/L \cdot (V_{bias} - V_t)^2$$

$$i_{rf} = g_m \cdot v_{rf}, \text{ where } g_m = \mu \cdot C_{ox} \cdot W/L \cdot (V_{bias} - V_t)$$

$$g_{m2} = 0.5 \cdot \mu \cdot C_{ox} \cdot W/L$$

The squared input voltage $v_{rf}^2$ comprises LF and RF components. Let the LF components be denoted $LP\{v_{rf}^2\}$. The LF component of $I_d$ will hence be

$$i_{LF} = g_{m2} \cdot LP\{v_{rf}^2\}$$

Thus it is:

$$i_{undesired} = 0.5 \cdot g_{m2} \cdot LP\{v_{rf}^2\} \frac{2T_s - T}{T} \quad (7)$$

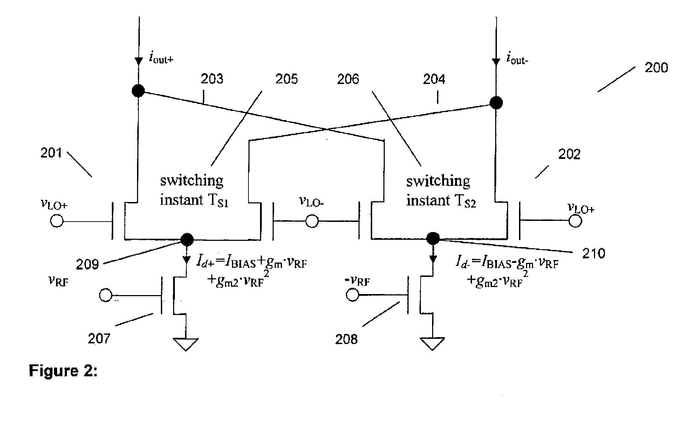

Figure 2 shows a double balanced mixer 200. It consists of two single balanced mixers 201, 202 with cross-coupled positive or negative output 203, 204 , respectively. It is assumed that due to parameter mismatches the switching instants of the two switching pairs 205, 206 in it are not identical as well, whereas for the sake of simplicity it is assumed that the RF-input transistors 207, 208 are matched. Each individual single-balanced mixer puts out an undesired LF current, which can be computed from Eq. (1). The total undesired LF-current for the double balanced mixer then computes as the sum of both individual undesired currents and will be:

$$i_{undesired} = g_{m2} \cdot LP\{v_{rf}^2\} \frac{T_{s2} - T_{s1}}{T},$$

where $T_{S2}$ and $T_{S1}$ are the individual switching instants which both deviate from T/2 in a random fashion.

For both the single and double balanced mixer IM2 develops in the RF-input transistors 207, 208 and then leaks into the output through mismatches in the switching transistors 205, 206. Namely, the IM2 is comprised by the drain current 209, 210 of the RF-input transistors. If the IM2 is removed from it before it enters the switches a substantial improvement of IIP2 can be achieved. IIP2 is the second order intercept point, the level of input signal at which the IM2 at the output is as high as the direct signal when a two-tone test is applied. In decibels it is S_out-IM2 = IIP2-S_in, where S_out is the output level, and S_in the input level.

It can be seen that, through Kirchhoff's current law, the output common mode of the mixer is identical to the common mode of the drain currents of the RF-transistors. For instance, if no means to reduce it are taken in a double-balanced gilbert mixer the output common mode is going to be:

$$i_{outcm} = 0.5\,(i_{out+}+i_{out-}) = 0.5 \cdot (I_{BIAS}+g_m \cdot v_{rf}+ g_{m2} \cdot v_{rf}^2 + I_{BIAS}-g_m \cdot v_{rf}+ g_{m2} \cdot LPv_{rf}^2).$$

Whereas odd-order distortion cancels out from the common-mode even order distortion contributes fully to it. Except for the DC the output common mode (CM) current hence comprises only the undesired IM2 which is identical to that flowing into the switching pair.

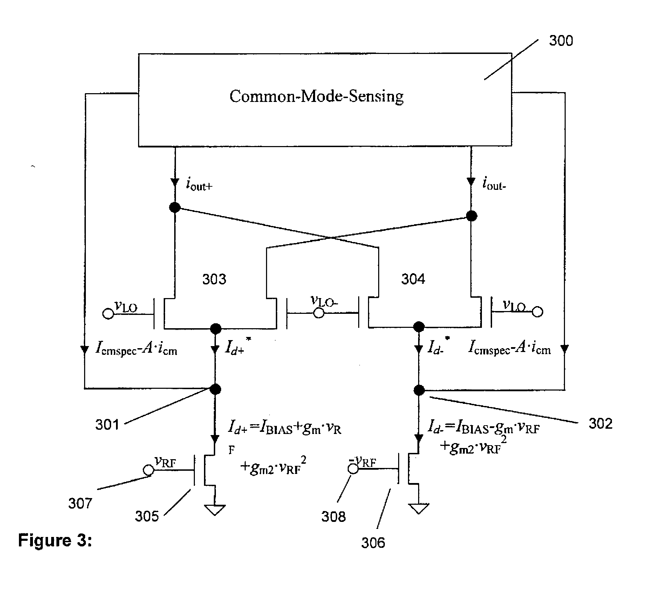

Figure 3 shows a double balanced mixer which includes an embodiment of the invention which removes second order distortion before it can leak into output differential mode (DM). The deviation of the output common mode from a specified CM-current, which is denoted $I_{cmspec}$, is sensed, amplified by a factor of $A$ within component 300 and then subtracted from the drain-currents 301, 302 of the RF-transistors. Instead of their drain currents $I_{d+}$ and $I_{d-}$ corrected drain currents $I_{d+}^{*}$ and $I_{d+}^{*}$ are now flowing into the switching pairs 303, 304. The CM of the corrected currents will now be

$$0.5 \cdot \left(I_{d+}^{*} + I_{d-}^{*}\right) = I_{cmspec} + \frac{1}{1+A}\left(I_{BIAS} + g_{m2}v_{rf}^2\right)$$

Hence the IM2 flowing into the switching pair is reduced by a factor $(1+A)^{-1}$ assuming the matching between the RF-input transistors is good. The IM2 at the output of the mixers (currents $i_{out+}$ and $i_{out-}$) will be reduced by the same amount.

Figure 3 shows an example mixer where the drain current is corrected directly through a subtraction of a correction current from the drains of the RF-transistors 305, 306. It will be appreciated that the correction could also be performed indirectly by influencing the gate-source voltage 307, 308 of the RF-input transistors.

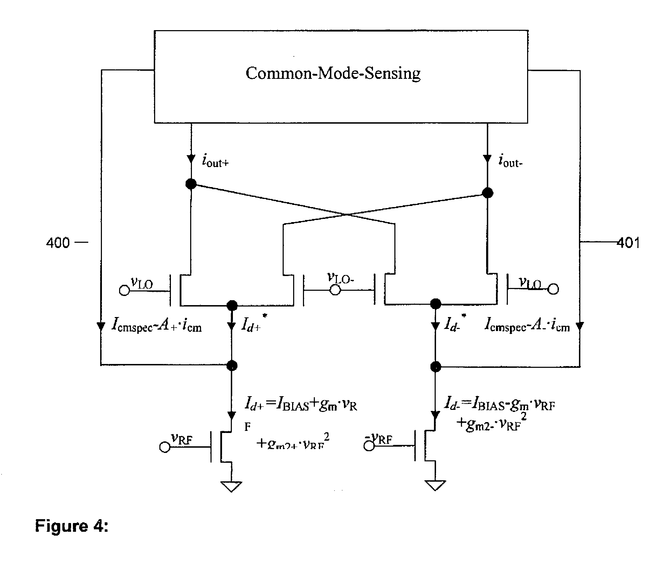

In the embodiment described above perfect matching between the RF-input transistors is assumed and mismatches occur only in the switching transistors. Practically, this may not be the case. Hence, even after removing IM2 from their drain current's CM in their differential mode output IM2 still may exist due to mismatched $g_{m2}$. In an alternative embodiment of the invention the still existent IM2 may be removed by deliberately mismatching the gains (A+ and A-) in the feedback paths 400, 401 as shown in Figure 4.

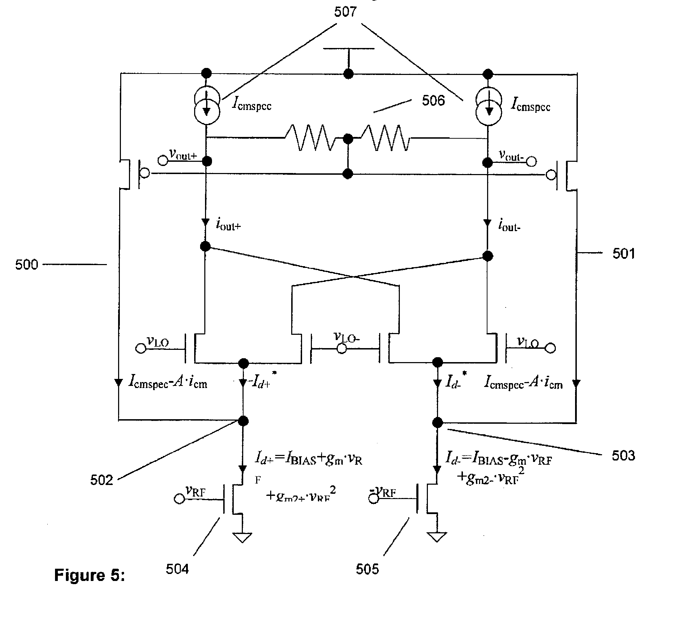

Figure 5 shows an example mixer where the CM-feedback 500, 501 to the drain-nodes 502, 503 of the RF-input transistors 504, 505 is established by using a resistive divider 506 and PMOS-transistors 507. The advantage of this implementation is simplicity. The disadvantage is that it may make the CM of the output voltage ($v_{out+}$-$v_{out-}$) VDD-dependent.

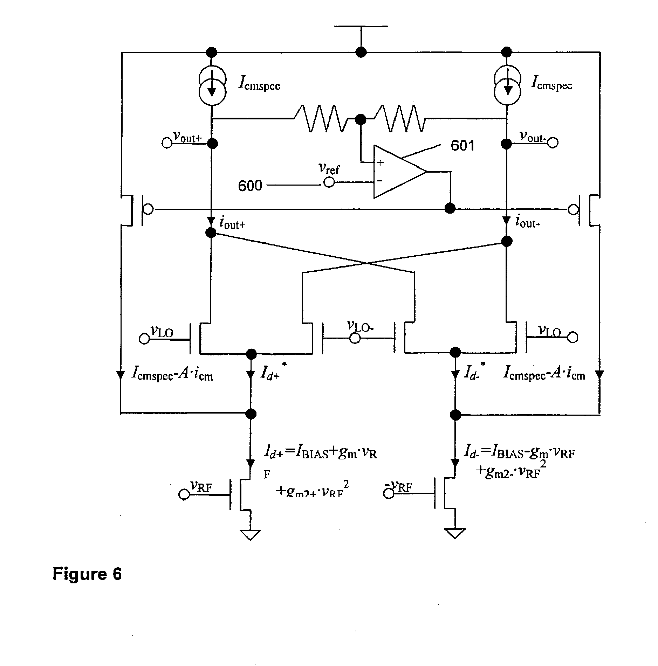

Figure 6 shows an embodiment of the invention where the CM of the output voltage is compared to a defined reference voltage 600 (which is ground-referenced). Therefore the output CM is no longer dependent on VDD. The disadvantage is that the operational amplifier 601 may destabilize the control-loop by its phase-shifts.

One potential advantage of embodiments of the present invention is that the removal of the CM from the drain-current of the RF-input transistors results in a significant reduction of IM2. According to simulation results the input referred second order intercept point (IIP2) of the mixer rises by approximately 40dB through the application of this invention.

A further potential advantage of embodiments of the present invention is that the invention provides means to control the output-CM of the mixer at the same time with the IM2-suppression. As a CM-loop has to be implemented anyway the implementation of the invention comes at no additional effort.

A further potential advantage of embodiments of the present invention is that the invention permits low odd-order distortion (e.g. IM3). Even though the invention would cover concepts that remove second order distortion from the drain current indirectly by influencing the gate-source-voltage of the RF-input transistors such concepts would lower the gate-source voltage at high input amplitudes. Thereby their transconductance would lower such that a gain compression (as indication of odd-order distortion) would occur much sooner than in the example given in Figure 3. By leaving the source-nodes of the RF-input transistors connected to the negative supply rail the transistors are allowed to increase their DC-current for high RF-input-voltages hence easily handling amplitudes as large as their saturation voltage.

A further potential advantage of embodiments of the present invention is that it is able to reduce IM2 without the use of coils and thus is particularly useful where there are area constraints. In addition, embodiments of the present invention avoid the problem where the use of coils results in lowering the drain impedance of the RF transistors, thereby reducing the achievable conversion gain.

While the present invention has been illustrated by the description of the embodiments thereof, and while the embodiments have been described in considerable detail, it is not the intention of the applicant to restrict or in any way limit the scope of the appended claims to such detail. Additional advantages and modifications will readily appear to those skilled in the art. Therefore, the invention in its broader aspects is not limited to the specific details representative apparatus and method, and illustrative examples shown and described. Accordingly, departures may be made from such details without departure from the scope of applicant's general inventive concept.

## Claims

1. A mixer for downconversion of RF signals, comprising:

   first and second RF transistors (305, 306, 504, 505), wherein sources of the first and second RF transistors are connected to a first supply voltage, a drain of the first RF transistor is connected to a first node (301, 502), a drain of the second RF transistor is connected to a second node (302, 503), and gates of the first and second RF transistors are configured to receive a first differential input signal;
   a first switching pair (303) of transistors comprising first and second transistors, wherein a drain of the first transistor is connected to a first output node, a drain of the second transistor is connected to a second output node, sources of the first and second transistors are connected to the first node, and gates of the first and second transistors are configured to receive a second differential input signal;
   a second switching pair (304) of transistors comprising third and fourth transistors, wherein a drain of the third transistor is connected to the first output node, a drain of the fourth transistor is connected to the second output node, sources of the third and fourth transistors are connected to the second node, and gates of the third and fourth transistors are configured to receive the second differential input signal; and
   first and second current sources (507), wherein the first current source is configured to supply a first current to the first output node and the second current source is configured to supply the first current to the second output node;
   **characterised in that** the mixer further comprises a common mode sensing component (300) configured to detect a deviation of a common mode current of the first and second output nodes from a specified output and to provide a first correction current to the drain (502) of the first RF transistor and provide a second correction current to the drain (503) of the second RF transistor, wherein the first correction current comprises the deviation multiplied by a first gain ($A_+$) and subtracted from the first current, and the second correction current comprises the deviation multiplied by a second gain ($A_-$) and subtracted from the first current.

2. A mixer as claimed in claim 1 further comprising an amplifier configured to amplify the deviations before the deviations are is subtracted from the drain currents of the first and second RF transistors.

3. A mixer as claimed in any preceding claim wherein the deviations are is directly subtracted from the drain currents of the RF transistors (305, 306, 504, 505).

4. A mixer as claimed in any preceding claim wherein the common mode sensing component comprises a resistive divider (506) and a PMOS-transistor.

5. A mixer as claimed in any preceding claim wherein the specified output is a ground reference defined voltage.

## Patentansprüche

1. Mischer zur Abwärtswandlung von RF-Signalen, umfassend:

   einen ersten und einen zweiten RF-Transistor (305, 306, 504, 505), wobei Sourcen des ersten und des zweiten RF-Transistors mit einer ersten Versorgungsspannung verbunden sind, ein Drain des ersten RF-Transistors mit einem ersten Knoten (301, 502) verbunden ist, ein Drain des zweiten RF-Transistors mit einem zweiten Knoten (302, 503) verbunden ist, und Gates des ersten und des zweiten RF-Transistors ausgelegt sind, ein erstes differentielles Eingangssignal zu empfangen;

ein erstes Schaltpaar (303) von Transistoren, das einen ersten und einen zweiten Transistor umfasst, wobei ein Drain des ersten Transistors mit einem ersten Ausgangsknoten verbunden ist, ein Drain des zweiten Transistors mit einem zweiten Ausgangsknoten verbunden ist, Sourcen des ersten und des zweiten Transistors mit dem ersten Knoten verbunden sind, und Gates des ersten und des zweiten Transistors ausgelegt sind, ein zweites differentielles Eingangssignal zu empfangen;

ein zweites Schaltpaar (304) von Transistoren, das einen dritten und einen vierten Transistor umfasst, wobei ein Drain des dritten Transistors mit dem ersten Ausgangsknoten verbunden ist, ein Drain des vierten Transistors mit dem zweiten Ausgangsknoten verbunden ist, Sourcen des dritten und des vierten Transistors mit dem zweiten Knoten verbunden sind, und Gates des dritten und des vierten Transistors ausgelegt sind, das zweite differentielle Eingangssignal zu empfangen; und

eine erste und eine zweite Stromquelle (507), wobei die erste Stromquelle ausgelegt ist, den ersten Ausgangsknoten mit einem ersten Strom zu versorgen und die zweite Stromquelle ausgelegt ist, den zweiten Ausgangsknoten mit dem ersten Strom zu versorgen;

**dadurch gekennzeichnet, dass** der Mischer ferner eine Gleichtakterfassungskomponente (300) umfasst, die ausgelegt ist, eine Abweichung eines Gleichtaktstroms des ersten und des zweiten Ausgangsknoten von einem spezifizierten Ausgang zu detektieren und einen ersten Korrekturstrom dem Drain (502) des ersten RF-Transistors bereitzustellen und einen zweiten Korrekturstrom dem Drain (503) des zweiten RF-Transistors bereitzustellen, wobei der erste Korrekturstrom die Abweichung multipliziert mit einer ersten Verstärkung ($A_+$) und vom ersten Strom subtrahiert umfasst und der zweite Korrekturstrom die Abweichung multipliziert mit einer zweiten Verstärkung ($A_-$) und vom ersten Strom subtrahiert umfasst.

2. Mischer gemäß Anspruch 1, welcher ferner einen Verstärker umfasst, der ausgelegt ist, die Abweichungen zu verstärken, bevor die Abweichungen von den Drainströmen des ersten und des zweiten RF-Transistors subtrahiert werden.

3. Mischer gemäß einem der vorhergehenden Ansprüche, wobei die Abweichungen direkt von den Drainströmen der RF-Transistoren (305, 306, 504, 505) subtrahiert werden.

4. Mischer gemäß einem der vorhergehenden Ansprüche, wobei die Gleichtakterfassungskomponente einen Widerstandsteiler (506) und einen PMOS-Transistor umfasst.

5. Mischer gemäß einem der vorhergehenden Ansprüche, wobei der spezifizierte Ausgang eine mit Massenreferenz definierte Spannung ist.

**Revendications**

1. Mélangeur pour l'abaissement de fréquence de signaux RF, comprenant :

des premier et deuxième transistors RF (305, 306, 504, 505), dans lequel des sources des premier et deuxième transistors RF sont connectées à une première tension d'alimentation, un drain du premier transistor RF est connecté à un premier noeud (301, 502), un drain du deuxième transistor RF est connecté à un deuxième noeud (302, 503), et des grilles des premier et deuxième transistors RF sont configurées pour recevoir un premier signal d'entrée différentiel ;

une première paire de commutation (303) de transistors comprenant des premier et deuxième transistors, dans lequel un drain du premier transistor est connecté à un premier noeud de sortie, un drain du deuxième transistor est connecté à un deuxième noeud de sortie, des sources des premier et deuxième transistors sont connectées au premier noeud, et des grilles des premier et deuxième transistors sont configurées pour recevoir un deuxième signal d'entrée différentiel ;

une deuxième paire de commutation (304) de transistors comprenant des troisième et quatrième transistors, dans lequel un drain du troisième transistor est connecté au premier noeud de sortie, un drain du quatrième transistor est connecté au deuxième noeud de sortie, des sources des troisième et quatrième transistors sont connectées au deuxième noeud, et des grilles des troisième et quatrième transistors sont configurées pour recevoir le deuxième signal d'entrée différentiel ; et

des première et deuxième sources de courant (507), dans lequel la première source de courant est configurée pour alimenter le premier noeud de sortie en un premier courant et la deuxième source de courant est configurée pour alimenter le deuxième noeud de sortie en le premier courant ;

**caractérisé en ce que** le mélangeur comprend en outre un composé de détection de mode commun (300) configuré pour détecter un écart entre un courant de mode commun des premier et deuxième noeuds de sortie et une sortie spécifiée et pour fournir un premier courant de correction au drain (502) du premier transistor RF et fournir un deuxième courant de correction au drain (503) du deuxième transistor RF,

dans lequel le premier courant de correction comprend l'écart multiplié par un premier gain ($A_+$) et soustrait du premier courant, et le deuxième courant de correction comprend l'écart multiplié par un deuxième gain ($A_-$) et soustrait du premier courant.

2. Mélangeur selon la revendication 1, comprenant en outre un amplificateur configuré pour amplifier les écarts avant que les écarts soient soustraits des courants de drain des premier et deuxième transistors RF.

3. Mélangeur selon l'une quelconque des revendications précédentes, dans lequel les écarts sont soustraits directement des courants de drain des transistors RF (305, 306, 504, 505).

4. Mélangeur selon l'une quelconque des revendications précédentes, dans lequel le composant de détection de mode commun comprend un diviseur résistif (506) et un transistor PMOS.

5. Mélangeur selon l'une quelconque des revendications précédentes, dans lequel la sortie spécifiée est une tension définie de référence à la masse.

Figure 1:

Figure 2:

300

Common-Mode-Sensing

$i_{out+}$                                                    $i_{out-}$

303                                                    304

$v_{LO}$                         $v_{LO-}$

$I_{cmspec}-A \cdot i_{cm}$      $I_{d+}^{*}$          $I_{d-}^{*}$      $I_{cmspec}-A \cdot i_{cm}$

301                                                    302

$I_{d+}=I_{BIAS}+g_m \cdot v_{RF}$          $I_{d-}=I_{BIAS}-g_m \cdot v_{RF}$
$+g_{m2} \cdot v_{RF}^{2}$                  $+g_{m2} \cdot v_{RF}^{2}$

$v_{RF}$                         $-v_{RF}$

307                              308

305                              306

**Figure 3:**

**Figure 4:**

**Figure 5:**

**Figure 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 20060040636 A


**Non-patent literature cited in the description**

• **BRANDOLINI et al.** A 750mV fully Integrated Direct Conversion Receiver Front-End for GSM in 90-nm CMOS. *IEEE Journal of Solid State Circuits,* June 2007, vol. 42 (6